(19) **Europäisches Patentamt** / **European Patent Office** / **Office européen des brevets**

(11) **EP 0 862 272 B1**

(12) **EUROPÄISCHE PATENTSCHRIFT**

(45) Veröffentlichungstag und Bekanntmachung des Hinweises auf die Patenterteilung:
**18.04.2007   Patentblatt 2007/16**

(51) Int Cl.:
*H03L 7/085* (2006.01)      *H03L 7/183* (2006.01)
*H04L 25/02* (2006.01)

(21) Anmeldenummer: **98100093.8**

(22) Anmeldetag: **07.01.1998**

(54) **Vorrichtung zur Gewinnung eines Taktsignals aus einem Datensignal und Bitratenerkennungseinrichtung zur Ermittlung einer Bitrate.**

Apparatus for extracting a clock signal from a data signal and device for determining a bit rate

Dispositif d'extraction d'un signal d'horloge à partir de signaux de données et appareil de détermination d'un débit

(84) Benannte Vertragsstaaten:
**DE DK FI FR GB IT**

(30) Priorität: **06.02.1997   DE 19704299**

(43) Veröffentlichungstag der Anmeldung:
**02.09.1998   Patentblatt 1998/36**

(73) Patentinhaber: **Deutsche Telekom AG**
**53113 Bonn (DE)**

(72) Erfinder: **Scheytt, Christoph**
**46282 Dorsten (DE)**

(56) Entgegenhaltungen:
**WO-A-91/10282           DE-A- 4 308 418**
**US-A- 4 993 048           US-A- 5 257 294**
**US-A- 5 512 860**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft eine Bitratenerkennungseinrichtung zur Ermittlung einer Bitrate eines Datensignalstroms. Die Erfindung betrifft desweiteren eine Vorrichtung zur Gewinnung eines Signals aus einem Datensignalstrom mit einer Phasen-/Frequenzregeleinrichtung, der der Datensignalstrom zuführbar ist, und mit einer mittels eines Datenworts umschaltbaren Frequenzteilereinrichtung, die im Rückkopplungszweig der Phasen-/Frequenzregeleinrichtung angeordnet ist und an dessen Ausgang das gewonnene Taktsignal abgreifbar ist.

Vorrichtungen zur Gewinnung eines Taktsignals aus einem Datensignalstrom sind bekannt. So ist beispielsweise im Maxim Engineering Journal, Heft 20, 1995, ein Produkt mit dem Namen MAX3270 offenbart, das mittels eines Phasen-/Frequenzregelkreises und eines im Rückkopplungszweig angeordneten programmierbaren Frequenzteilers das Taktsignal aus dem zugeführten Datensignalstrom gewinnt. Da der Phasen-/Frequenzregelkreis lediglich innerhalb eines bestimmten Frequenz- beziehungsweise Taktbereichs arbeitet, läßt sich mit Hilfe des Frequenzteilers ein Umschalten zwischen unterschiedlichen Frequenzbeziehungsweise Taktbereichen durchführen. Das Umschalten selbst erfolgt durch Anlegen unterschiedlicher Datensignale an den Frequenzteiler. Obgleich sich dieser Baustein zur Rückgewinnung des Taktsignals aus Datensignalströmen mit unterschiedlichsten Bitraten verwenden läßt, ist dessen Einsatz jedoch dann nicht möglich, wenn der zugeführte Datensignalstrom zwischen unterschiedlichen Bitraten wechselt. Der Baustein ist nämlich nicht in der Lage, die jeweiligen Frequenz- beziehungsweise Taktbereiche zu erkennen und entsprechend den Frequenzteiler einzustellen. Dies muß vor Inbetriebnahme von außen erfolgen.

In einer Veröffentlichung von D. Potson und A. Buchholz ("A 143-360 Mbit/s Auto-Rate Selecting Date-Retimer Chip for Serial Digital Video Signals", IEEE International Solid-State Circuits Conference 1996, digest of technical papers, vol.39, pp.196-197) ist eine Taktrückgewinnungsschaltung offenbart, die Datensignalströme verschiedener Bitraten verarbeiten kann, wobei die Umschaltung zwischen den verschiedenen Frequenz- beziehungsweise Taktbereichen automatisch erfolgt. Die Umschaltung wird durch die Frequenzsensitivität des Phasen-/Frequenzdetektors erreicht, der eine VCO-Steuerspannung so regelt, daß der Phasen-/Frequenzregelkreis auf der neuen Frequenz einrastet. Im Gegensatz zu dem vorgenannten Beispiel wird hier jedoch kein Frequenzteiler eingesetzt. Diese Schaltung hat den Nachteil, daß die Taktrückgewinnung nur innerhalb eines eingeschränkten Frequenz- beziehungsweise Taktbereichs möglich ist. Verursacht wird diese Einschränkung durch die VCO-Schaltung, deren Verstimmbereich aus schaltungstechnischen Gründen nicht beliebig groß gemacht werden kann. Eine weitere Einschränkung wird dadurch verursacht, daß die üblicherweise verwendeten Phasen-/Frequenzdetektoren nur in einem eingeschränkten Frequenzbereich arbeiten.

Die Patentschrift US-A-5 512 860 zeigt eine Schaltung zur Gewinnung eines Taktsignals aus einem Datensignalstrom mit einer Phasen-/Frequenzregeleinrichtung (PLL) und mit einer mittels eines Datenworts umschaltbaren Frequenzteilereinrichtung, die im Rückkopplungszweig der Phasen-/Frequenzregeleinrichtung angeordnet ist und an deren Ausgang das gewonnene Taktsignal abgreifbar ist. Dabei ist die Frequenzteilereinrichtung durch ein zugeführtes Datenwort einstellbar, wodurch die Phasen-/Frequenzregeleinrichtung auf eine Bitrate eingestellt wird.

Die Offenlegungsschrift DE 43 08 418 A zeigt eine Schaltung zur Erkennung der Bitrate aus einem Datensignalstrom mit Hilfe eines Referenzsignals, wobei die Bitrate durch Ausmessen der Dauer eines Startbits gewonnen wird. Ein Datenrückgewinnungsbaustein wird entsprechend der erkannten Bitrate programmiert.

Die Aufgabe der vorliegenden Erfindung besteht deshalb darin, eine Vorrichtung zur Gewinnung eines Taktsignals anzugeben, mit der Datensignalströme unterschiedlichster Bitraten verarbeitbar sind.

Diese Aufgabe wird durch eine Vorrichtung gelöst, die die Merkmale des Anspruchs 1 aufweist.

Dadurch, daß eine Bitratenerkennungseinrichtung vorgesehen ist, die auf der Basis zumindest eines, vorzugsweise zweier Referenzfrequenzsignale die Bitrate des Datensignalstroms ermittelt und entsprechend codiert als Datenwort der Frequenzteilereinrichtung zuführt, läßt sich die Phasen-/Frequenzregeleinrichtung auf unterschiedliche Frequenzbereiche einrasten, so daß Datensignalströme mit unterschiedlichen Bitraten automatisch verarbeitbar sind. Eine Umprogrammierung des Frequenzteilers von außen ist dabei nicht notwendig.

Im Gegensatz zu den bekannten Schaltungen arbeitet die erfindungsgemäße Vorrichtung zur Gewinnung eines Taktsignals zweistufig. In der ersten Stufe wird mittels der Bitratenerkennungseinrichtung die Phasen-/Frequenzregeleinrichtung auf einen bestimmten Frequenzbereich beziehungsweise Taktbereich eingestellt. In einem zweiten Schritt erfolgt dann die Feinabstimmung der Frequenz beziehungsweise des Taktes, die durch die Phasen-/Frequenzregeleinrichtung selbst erfolgt. Dadurch ist es nicht wie im Stand der Technik notwendig, den Verstimmbereich der VCO-Schaltung in der Phasen-/Frequenzregeleinrichtung groß zu wählen und folglich hohen schaltungstechnischen Aufwand zu betreiben.

Die Bitratenerkennungseinrichtung umfaßt zumindest eine, vorzugsweise zumindest zwei Flankendichte-Meßeinrichtungen, denen jeweils der Datensignalstrom sowie ein Referenzfrequenzsignal zuführbar ist und deren Ausgangssignale das zur Einstellung der Frequenzteilereinrichtung notwendige Datenwort bilden.

Die Flankendichte-Meßeinrichtung (im folgenden kurz FDM-Einrichtung genannt) umfaßt eine Abtasteinheit, eine Flankendetektionseinheit, eine Mittelungseinheit und eine Entscheidungseinheit. Vorzugsweise weist die Abtasteinheit ein Flipflop auf, dem als Taktsignal ein Referenzfrequenzsignal und als Eingangssignal der Datensignalstrom zuführbar ist. Die Flankendetektionseinheit umfaßt vorzugsweise ein Flipflop und ein XOR-Gatter, wobei ein Eingang des Flipflops und ein Eingang des XOR-Gatters mit dem Ausgang der Abtasteinheit und der andere Eingang des XOR-Gatters mit dem Ausgang des flipflops verbunden ist. Die Mittelungseinheit weist vorzugsweise ein Tiefpaßfilter auf, dessen Eingang mit dem Ausgang der Flankendetektionseinheit verbunden ist. Die Entscheidungseinheit umfaßt vorzugsweise eine Komparatorschaltung und ein Flipflop, wobei ein Eingang der Komparatorschaltung mit dem Ausgang der Mittelungseinheit und der andere Eingang mit einer Referenzspannungsquelle verbunden ist, und wobei der Ausgang der Komparatorschaltung mit einem Eingang des Flipflops verbunden ist. Das Ausgangssignal dieses Flipflops bildet dann ein Bit des der Frequenzteilereinrichtung zugeführten Datenworts.

Die Anzahl der erkannten Frequenz- beziehungsweise Taktbereiche ist unmittelbar abhängig von der Anzahl der verwendeten FDM-Einrichtungen. So lassen sich hier beispielsweise bei zwei eingesetzten FDM-Einrichtungen drei unterschiedliche Frequenz- beziehungsweise Taktbereiche erkennen. Durch die Verwendung von mehr als zwei FDM-Einrichtungen läßt sich die Zahl der erkennbaren Frequenzbereiche weiter erhöhen.

Die Erfindung wird nun anhand eines Ausführungsbeispiels mit Bezug auf die Zeichnungen näher erläutert. Dabei zeigen:

Figur 1    ein Blockdiagramm einer Schaltung zur Regenerierung eines verrauschten Datensignals mit einer erfindungsgemäßen Vorrichtung zur Gewinnung eines Taktsignals;

Figur 2    ein Blockdiagramm einer Bitraten-Erkennungseinrichtung, und

Figur 3    ein Blockdiagramm einer FDM-Einrichtung, die in einer Bitraten-Erkennungseinrichtung gemäß Figur 2 eingesetzt ist.

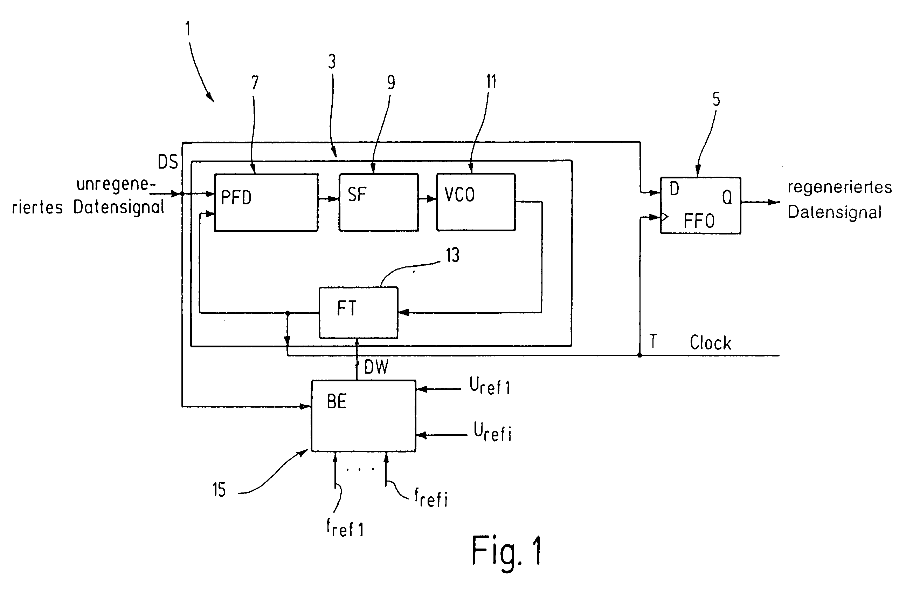

In Figur 1 ist der grundsätzliche Aufbau einer Datenregenerationsschaltung 1 gezeigt. Sie umfaßt ein Phasen- beziehungsweise Phasen-/Frequenzregelkreis 3 und ein Regenerator-Flipflop 5. Der Phasen-/Frequenzregelkreis 3 umfaßt seinerseits einen Phasen- /Frequenzdetektor 7, ein Schleifenfilter 9, eine VCO-Schaltung 11 (Voltage Control Oscillator) und einen umschaltbaren Frequenzteiler 13. Die vorgenannten Funktionseinheiten sind zu einem Regelkreis verschaltet, wobei das Ausgangssignal der VCO-Schaltung 11 über den Frequenzteiler 13 zu einem Eingang des Phasen-/Frequenzdetektors 7 rückgekoppelt wird, während der andere Eingang des Phasen-/Frequenzdetektors 7 mit einem zu regenerierenden Datensignalstrom DS beaufschlagt ist. Das Ausgangssignal des im Rückkopplungszweig des Frequenzregelkreises 3 liegenden Frequenzteilers 13 bildet dann das gewünschte aus dem Datensignalstrom gewonnene Taktsignal T. Die Funktionsweise eines solchen Phasen-/Frequenzregelkreises sowie die jeweilige Funktionsweise des Frequenzdetektors 7, des Schleifenfilters 9, der VCO-Schaltung 11 und des Frequenzteilers 13 ist aus dem Stand der Technik bekannt, so daß auf eine genauere Erläuterung verzichtet wird.

Das rückgewonnene Taktsignal T wird dem Taktsignaleingang des Regenerator-Flipflops 5 zugeführt, dessen Dateneingang D mit dem Datensignalstrom DS beaufschlagt ist. Das am Ausgang Q dieses Regenerator-Flipflops 5 abgreifbare Signal stellt dann das regenerierte Datensignal dar.

Dem Phasen-/Frequenzregelkreis 3, insbesondere dem Frequenzteiler 13, ist eine Bitratenerkennungsschaltung 15 zugeordnet, der die Aufgabe zufällt, die Bitraten des Datensignalstroms DS zu ermitteln und abhängig davon das Teilerverhältnis des Frequenzteilers 13 einzustellen. Dazu wird der Bitratenerkennungsschaltung 15 neben dem Datensignalstrom DS zumindest eine, vorzugsweise zumindest zwei Referenzfrequenzsignale $f_{ref1}$, $f_{refi}$ sowie wenigstens ein, im vorliegenden Ausführungsbeispiel mehrere Referenzspannungssignale $U_{ref1}$, $U_{refi}$ zugeführt. Auf der Grundlage dieser Referenzwerte ermittelt die Bitratenerkennungsschaltung 15 den Frequenzbereich des Datensignalstroms, codiert diesen Wert und überträgt ihn als Datenwort DW an den Frequenzteiler 13. Der Frequenzteiler 13 ist derart ausgebildet, daß er ein dem übermittelten Datenwort zugeordnetes Teilerverhältnis einstellt.

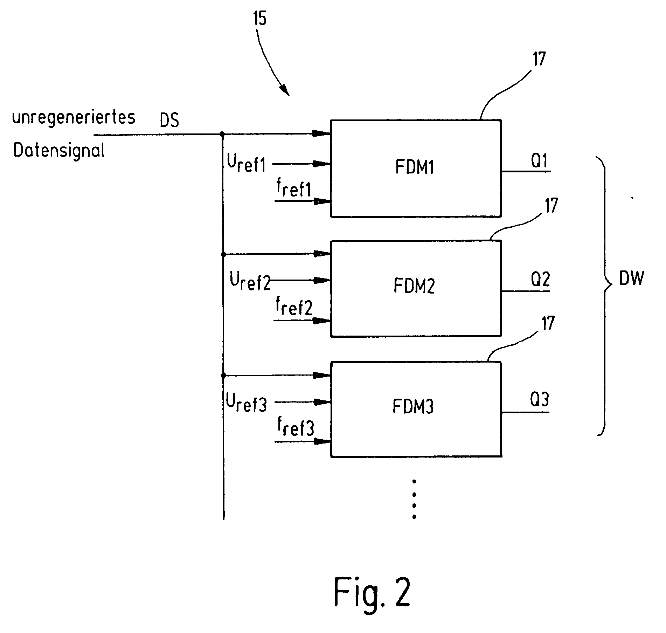

Der Aufbau der Bitratenerkennungsschaltung 15 ist in der Figur 2 näher beschrieben. Die Bitratenerkennungsschaltung 15 umfaßt zumindest eine, im vorliegenden Ausführungsbeispiel mehrere Flankendichte-Meßschaltungen 17, die parallel zueinander angeordnet sind. Sie alle werden einerseits mit dem unregenerierten Datensignalstrom DS versorgt. Andererseits wird jeder Flankendichte-Meßschaltung 17 ein Spannungsreferenzsignal $U_{ref}$ sowie ein Referenzfrequenzsignal $f_{ref}$ zugeführt. Auf der Basis der Referenzwerte ermittelt jede der Flankendichte-Meß-schaltungen 17 ein binäres Datum Q, das ein Bit des Datenworts DW darstellt. Dieses an den Frequenzteiler 13 übermittelte Datenwort DW wird folglich durch die binären Ausgangsdaten Q der Flankendichte-Meßschaltung 17 gebildet.

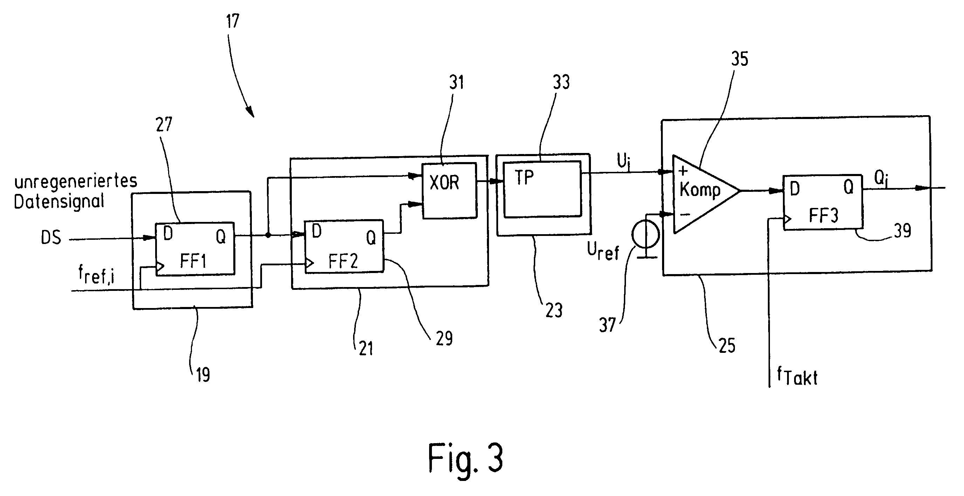

Der Aufbau einer solchen Flankendichte-Meßschaltung 17 ist in Figur 3 dargestellt. Sie umfaßt in Reihenschaltung eine Abtasteinheit 19, eine Flankendetektionseinheit 21, eine Mittelungseinheit 23 sowie eine Entscheidungseinheit 25.

Die Abtasteinheit 19 umfaßt ein Flipflop 27, dessen Dateneingang D der unregenerierte Datensignalstrom DS zugeführt ist. Der Takteingang des Flipflops 27 wird mit dem Referenzfrequenzsignal $f_{ref}$ beaufschlagt.

Die Flankendetektionseinheit 21 umfaßt ein Flipflop 27 sowie ein XOR-Gatter 31. Der Dateneingang D des Flipflops 29 ist mit dem Ausgang Q des Flipflops 27 verbunden, der seinerseits mit einem Eingang des XOR-Gatters 31 verbunden ist. Der zweite Eingang des XOR-Gatters 31 ist mit dem Ausgang Q des Flipflops 29 verbunden. Auch diesem Flipflop 29 wird als Taktsignal das Referenzfrequenzsignal $f_{ref}$ zugeführt.

Die Mittelungseinheit 23 umfaßt ein Tiefpaßfilter 33, dessen Eingang mit dem Ausgang des XOR-Gatters 31 verbunden ist.

Die Entscheidungseinheit 25 umfaßt einen Komparator 35, dessen invertierender Eingang mit einer eine Referenzspannung $U_{ref}$ liefernde Spannungsquelle 37 und dessen anderer Eingang mit dem Ausgang des Tiefpaßfilters 33 verbunden ist. Der Ausgang der Komparator-Schaltung 35 ist mit einem Dateneingang eines Flipflops 39 verbunden, an dessen Ausgangsanschluß Q ein Bit des Datenworts DW abgreifbar ist. Das Flipflop 39 wird mit einem Taktsignal $f_{Takt}$ versorgt, vorzugsweise mit einem langsamen Systemtakt.

Die Bitratenerkennung funktioniert nun wie folgt:

Zunächst wird das ungenerierte Datensignal DS in der Abtasteinheit 19 bei einer Frequenz $f_{ref}$ abgetastet. Abhängig von der Bitrate des Datensignalstroms findet entweder eine Unterabtastung, eine Überabtastung oder eine Abtastung mit der ungefähren Taktfrequenz statt.

Auf die Abtastung folgt in der Flankendetektionseinheit 21 eine Flankendetektion, das heißt, es findet eine Detektion von 0=>1 beziehungsweise 1=>0-Übergängen im Datensignalstrom statt.

Das Ausgangssignal der Flankendetektionseinheit wird mittels des Tiefpaßfilters 33 in der Mittelungseinheit 23 gemittelt, so daß an dessen Ausgang Spannungen anliegen, die proportional der mittleren relativen Häufigkeit von Datensignalflanken im Abtastsignal sind.

Das gemittelte Ausgangssignal wird durch den Komparator 35 mit einer Referenzspannung $U_{ref}$ verglichen, wobei durch das nachgeschaltete Flipflop 39 ein eindeutiges binäres Entscheidungsdatum erzeugt wird.

Anhand eines konkreten Beispiels soll die Funktion der Bitratenerkennungsschaltung 15 nochmals erläutert werden.

Ausgangspunkt soll ein Datenübertragungssystem sein, bei dem die Daten mit drei unterschiedlichen Bitraten, nämlich 155,52 Mbit/s (STM-1), 622,08 Mbit/s (STM-4) und 2,48832 Gbit/s (STM-16), übertragen werden. Die bisher bekannten Schaltungen zur Gewinnung eines Taktsignals arbeiten in diesem Fall nicht automatisch, da der Frequenzbereich zu groß ist.

Zur Erkennung dreier unterschiedlicher Bitraten umfaßt die Bitratenerkennungsschaltung 15 in diesem konkreten Beispiel zwei Flankendichte-Meßschaltungen 17, wie sie in Figur 3 erläutert sind. Dabei wird als erste Referenzfrequenz der Wert 2,56 GHz und als zweite Referenzfrequenz 640 MHz = 2,56 GHz/4 verwendet. Bei der Wahl der Referenzfrequenzen ist darauf zu achten, daß sie nicht mit der Frequenz des Datensignalstroms übereinstimmen. Als Referenzspannung wird ein Wert $0{,}3 \cdot U_0$ verwendet, wobei $U_0$ gleich der Spannung der logischen 1 ist. In der folgenden Tabelle ist ausgeführt, welche Ausgangssignale der beiden Entscheidungseinheiten 25 sich ergeben, und welche Bitrate sie codieren.

|  | Ausgangssignale Entscheidungseinheiten 25 | |
|---|---|---|
| Bitrate $f_B$ | A | B |
| 2,48 Gbit/s | H | H |
| 622 Mbit/s | L | H |
| 155 Mbit/s | L | L |

Die vorgenannte Funktion der Bitratenerkennungsschaltung 15 soll nun auf der Grundlage des oben genannten konkreten Beispiels analytisch beschrieben werden.

Die relative Häufigkeit h von Datenflanken in einem zufälligen, binären, seriellen Datensignal beträgt 0,45 bis 0,5. Im folgenden sei $f_{ref1} = 4 \cdot f_{ref2}$.

Ist nun die Bitrate $f_B$ gleich $f_{ref1} = 4 \cdot f_{ref2}$, dann gilt für $U_A$ und $U_B$:

$$U_A = h \cdot U_0$$

$$U_B = (4 \cdot h(1-h)^3 + 4 \cdot h^3(1-h))U_0 \approx 0{,}5 U_0$$

wobei $U_0$ gleich der Spannung der logischen "Eins" (H) ist und die logische "Null" (L) der Spannung 0V entspricht.

Ist die Bitrate $f_B$ gleich $f_{ref1}/4$-$f_{ref2}$, dann betragen $U_A$ und $U_B$:

$$U_A = \frac{h}{4} \cdot U_0$$

$$U_B = h \cdot U_0$$

Ist schließlich die Bitrate $f_B$ gleich $f_{ref1}/16$=$f_{ref2}/4$, dann gilt:

$$U_A = \frac{h}{16} \cdot U_0$$

$$U_B = \frac{h}{4} \cdot U_0$$

Wählt man einen entsprechenden $U_{ref}$-Wert von $0,3 \cdot U_0$ am Eingang der Komparatoren, dann erhält man an den Ausgängen QA und QB der Schaltung ein zwei Bit breites Datenwort, das die aktuelle Bitrate angibt.

In der folgenden Tabelle sind die möglichen Fälle und Ausgangswerte angegeben:

| $f_B$ | $U_A$ | $U_B$ | $Q_A$ | $Q_B$ |
|---|---|---|---|---|
| $f_B = f_{ref1}$ | $h*U_0$ | $0,5*U_0$ | H | H |
| $f_B = 4*f_{ref1}$ | $h/4*U_0$ | $h*U_0$ | L | H |
| $f_B = 16*f_{ref1}$ | $h/16*U_0$ | $h/4*U_0$ | L | L |

Da die Referenzfrequenzen nicht sehr genau sein müssen, kann unter Umständen auf externe Referenzfrequenzen verzichtet werden. Falls nämlich der Verstimmbereich des VCO nicht zu groß ist, kann die VCO-Frequenz und ein entsprechender Ausgang des Frequenzteilers verwendet werden.

Werden externe Referenzfrequenzen verwendet, werden Frequenzen benötigt, die um einige Prozent von den STM-4 und STM-16-Taktfrequenzen abweichen. Dies ist notwendig, da sonst beim abtastenden Flipflop bei ungünstiger Phasenlage des Datensignals über einen längeren Zeitraum hinweg Setup- und Hold-Zeit-Verletzungen und damit viele fehlerhafte Abtastungen in Folge in der Abtasteinheit und in der Flankendetektionseinheit auftreten können. Fehlerhafte Abtastungen in langer Folge können von den Tiefpässen nicht herausgemittelt werden.

Weichen die Taktfrequenzen voneinander ab, mitteln sich die Fehlabtastungen heraus, weil dann nur kurze Folgen von Fehlabtastungen auftreten. Abweichungen von einigen Prozent reichen dabei aus.

Ein weiteres Beispiel der Erfindung besteht darin, die beschriebene Schaltung 1 zu einem Phasen-/Frequenzkreis mit extrem großem Ziehbereich auszubauen, zum Beispiel zur Frequenzsynthese oder FM-Demodulation. Dabei dient die Bitratenerkennungsschaltung der Erkennung des Frequenzbandes, aus dem die aktuelle Referenzfrequenz stammt. Die Frequenzsensitivität des Phasen-/Frequenzdetektors ermöglicht anschließend das Einrasten des Phasen-/Frequenzregelkreises auf der Zielfrequenz.

**Patentansprüche**

1. Vorrichtung zur Gewinnung eines Taktsignals aus einem Datensignalstrom mit einer Phasen-/Frequenzregeleinrichtung (3), der der Datensignalstrom zuführbar ist, und mit einer mittels eines Datenworts (DW) umschaltbaren Frequenzteilereinrichtung (13), die im Rückkopplungszweig der Phasen-/Frequenzregeleinrichtung angeordnet ist und an deren Ausgang das gewonnene Taktsignal (T) abgreifbar ist, **dadurch gekennzeichnet, daß** eine Bitratenerkennungseinrichtung (15) vorgesehen ist, der der Datensignalstrom und zumindest ein Referenzfrequenzsignal ($f_{ref}$) zuführbar sind, und die ein bitratenabhängiges, der Frequenzteilereinrichtung (13) zuführbares Datenwort (DW) erzeugt, wobei die Bitratenerkennungseinrichtung (15) zumindest eine Flankendichte-Meßeinrichtung (17) umfaßt, die eine den Datensignalstrom und ein Referenzfrequenzsignal ($f_{ref}$) empfangende, ein Abtastsignal liefernde Abtasteinheit (19), eine dieser nachgeschaltete Flankendetektionseinheit (21), eine dieser nachgeschaltete Mittelungseinheit (23), die Spannungen proportional der mittleren relativen Häufigkeit von Datensignalflanken im Abtastsignal liefert, und eine dieser nachgeschaltete, ein binäres Datum erzeugende Entscheidungseinheit (25) aufweist.

2. Vorrichtung nach Anspruch 1, **dadurch gekennzeichnet, daß** der Bitratenerkennungseinrichtung (15) zumindest zwei Referenzfrequenzsignale zuführbar sind.

3. Vorrichtung nach Anspruch 1, **dadurch gekennzeichnet, daß** die Abtasteinheit (19) ein Flipflop (27) umfaßt, der als Taktsignal ein Referenzfrequenzsignal ($f_{ref}$) und als Eingangssignal der Datensignalstrom (DS) zuführbar ist.

4. Vorrichtung nach Anspruch 3, **dadurch gekennzeichnet, daß** die Flankendetektionseinheit (21) ein Flipflop (29) und ein XOR-Gatter (31) umfaßt, wobei ein Eingang (D) des Flipflops (29) und ein Eingang des XOR-Gatters (31) mit dem Ausgang der Abtasteinheit (19) und der andere Eingang des XOR-Gatters (31) mit dem Ausgang des Flipflops (29) verbunden ist, wobei dem Taktsignaleingang des Flipflops (29) das Referenzfrequenzsignal ($f_{ref}$) zuführbar ist.

5. Vorrichtung nach Anspruch 4, **dadurch gekennzeichnet, daß** die Mittelungseinheit (23) ein Tiefpaßfilter (33) umfaßt, dessen Eingang mit dem Ausgang des XOR-Gatters (31) der Flankendetektionseinheit (21) verbunden ist.

6. Vorrichtung nach Anspruch 5, **dadurch gekennzeichnet, daß** die Entscheidungseinheit (25) eine Komparatorschaltung (35) und ein Flipflop (39) umfaßt, wobei ein Eingang der Komparatorschaltung (35) mit dem Ausgang der Mittelungseinheit (23) verbunden ist, dem weiteren Eingang der Komparatorschaltung (35) ein Referenzspannungssignal ($U_{ref}$) zuführbar ist und der Ausgang der Komparatorschaltung (35) mit einem Eingang (D) des Flipflops (39) verbunden ist.

7. Vorrichtung nach Anspruch 1, **dadurch gekennzeichnet, daß** zumindest zwei Flankendetektionsmeßeinrichtungen (17) vorgesehen sind.

**Claims**

1. Device for extracting a clock signal from a data signal stream, having a phase/frequency control device (3) to which the data signal stream can be supplied, and having a frequency divider device (13) that is switchable by means of a data word (DW) and is arranged in the feedback path of the phase/frequency control device and from whose output the extracted clock signal (T) can be obtained, **characterized in that** there is provided a bit rate detection device (15) to which the data signal stream and at least one reference frequency signal ($f_{ref}$) can be supplied and that generates a bit-rate-dependent data word (DW) that can be supplied to the frequency divider device (13), wherein the bit rate detection device (15) includes at least one edge density measurement device (17) that has a sampling unit (19) that receives the data signal stream and a reference frequency signal ($f_{ref}$) and provides a sampled signal, and has, following said sampling unit, an edge detection unit (21), and has, following said edge detection unit, an averaging unit (23) that delivers voltages proportional to the average relative frequency of data signal edges in the sampled signal, and has, following said averaging unit, a decision unit (25) that produces binary data.

2. Device according to claim 1, **characterized in that** the bit rate detection device (15) can be provided with at least two reference frequency signals.

3. Device according to claim 1, **characterized in that** the sampling unit (19) has a flip-flop (27) to which a reference frequency signal ($f_{ref}$) can be provided as the clock signal, and to which the data signal stream (DS) can be provided as the input signal.

4. Device according to claim 3, **characterized in that** the edge detection unit (21) has a flip-flop (29) and an XOR gate (31), wherein one input (D) of the flip-flop (29) and one input of the XOR gate (31) are connected to the output of the sampling unit (19), and the other input of the XOR gate (31) is connected to the output of the flip-flop (29), wherein the clock signal input of the flip-flop (29) can be provided with the reference frequency signal ($f_{ref}$).

5. Device according to claim 4, **characterized in that** the averaging unit (23) includes a low-pass filter (33) whose input is connected to the output of the XOR gate (31) of the edge detection unit (21).

6. Device according to claim 5, **characterized in that** the decision unit (25) includes a comparator circuit (35) and a flip-flop (39), wherein one input of the comparator circuit (35) is connected to the output of the averaging unit (23), the other input of the comparator circuit (35) can be supplied with a reference voltage signal ($U_{ref}$), and the output of the comparator circuit (35) is connected to the input (D) of the flip-flop (39).

7. Device according to claim 1, **characterized in that** at least two edge detection measurement units (17) are provided.

**Revendications**

1. Dispositif d'extraction d'un signal d'horloge à partir d'un flux de signaux de données à l'aide d'un dispositif de réglage de phase / de fréquence (3) auquel peut être amené le flux de signaux de données, et à l'aide d'un diviseur de fréquence (13) commutable au moyen d'un mot de données (DW) et disposé dans la branche de réaction du dispositif de réglage de phase / de fréquence et à la sortie duquel peut être récupéré le signal d'horloge (T) extrait, **caractérisé en ce qu'**un dispositif de détection du débit binaire (15) est prévu auquel peuvent être amenés le flux de signaux de données et au moins un signal de fréquence de référence ($f_{ref}$), et qui génère un mot de données (DW) qui est fonction du débit binaire et qui peut être amené au diviseur de fréquence (13), le dispositif de détection du débit binaire (15) comprenant au moins un dispositif de mesure de la densité du front (17) comportant une unité d'échantillonnage (19) recevant le flux de signaux de données et un signal de fréquence de référence ($f_{ref}$) et fournissant un signal échantillonné, une unité de détection de front (21) disposée en aval de celle-ci, une unité de moyennage (23) disposée en aval de celle-ci fournissant des tensions proportionnellement à la fréquence relative moyenne d'apparition de fronts de signaux de données dans le signal échantillonné, une unité de décision (25) disposée en aval de celle-ci générant une donnée binaire.

2. Dispositif selon la revendication 1, **caractérisé en ce qu'**au moins deux signaux de fréquence de référence peuvent être amenés au dispositif de détection du débit binaire (15).

3. Dispositif selon la revendication 1, **caractérisé en ce que** l'unité d'échantillonnage (19) comporte une bascule (27) à laquelle peuvent être amenés un signal de fréquence de référence ($f_{ref}$) comme signal d'horloge et le flux de signaux de données (DS) comme signal d'entrée.

4. Dispositif selon la revendication 3, **caractérisé en ce que** l'unité de détection de front (21) comprend une bascule (29) et une porte OU EXCLUSIF (31), une entrée (D) de la bascule (29) et une entrée de la porte OU EXCLUSIF (31) étant reliées à la sortie de l'unité d'échantillonnage (19) et l'autre entrée de la porte OU EXCLUSIF (31) étant reliée à la sortie de la bascule (29), le signal de fréquence de référence ($f_{ref}$) pouvant être amené à l'entrée du signal d'horloge de la bascule (29).

5. Dispositif selon la revendication 4, **caractérisé en ce que** l'unité de moyennage (23) comprend un filtre passe-bas (33) dont l'entrée est reliée à la sortie de la porte OU EXCLUSIF (31) de l'unité de détection de front (21).

6. Dispositif selon la revendication 5, **caractérisé en ce que** l'unité de décision (25) comprend un circuit comparateur (35) et une bascule (39), une entrée du circuit comparateur (35) étant reliée à la sortie de l'unité de moyennage (23), un signal de tension de référence ($U_{ref}$) pouvant être amené à l'autre entrée du circuit comparateur (35) et la sortie du circuit comparateur (35) étant reliée à une entrée (D) de la bascule (39).

7. Dispositif selon la revendication 1, **caractérisé en ce qu'**au moins deux dispositifs de mesure de détection de front (17) sont prévus.

Fig. 1

EP 0 862 272 B1

unregeneriertes DS
Datensignal

$U_{ref1}$

$f_{ref1}$

15

17

FDM1 → Q1

17

$U_{ref2}$

$f_{ref2}$

FDM2 → Q2

17

$U_{ref3}$

$f_{ref3}$

FDM3 → Q3

DW

Fig. 2

Fig. 3

EP 0 862 272 B1